# EUROPEAN PATENT APPLICATION

(11) **EP 2 051 307 A2**
(43) Date of publication of application: **22.04.2009**
(21) Application number: 07254367.1
(22) Date of filing: 05.11.2007
(51) Int. Cl.: H01L 31/18

(54) **Method of fast hydrogen passivation to solar cells made of crystalline silicon**

(30) Priority: 17.10.2007 US 873423
(71) Applicant: Industrial Technology Research Institute, Chutung Hsinchu Taiwan 310 (CN); National Tsing Hua University, Hsinchu 300 (TW)
(72) Inventor: Son, Wen-Ching, Pingihen City Taoyuan County 324 Taiwan (CN); Chen, Chien-Hsun, East District Tainan City 701 Taiwan (CN); Gan, Jon-Yiew, East District Hsinchu City 300 Taiwan (CN); Hwang, Jenn-Chang, East District Hsinchu City 300 Taiwan (CN); Kou, Chwung-Shan, East District Hsinchu City 300 Taiwan (CN); Wang, Chih-Wei, Jhongli City Taoyuan County 320 Taiwan (CN); Lin, Juan-You, Singang Township Chiayi County 616 Taiwan (CN)
(74) Representative: Chamberlain, Alan James

(57) **Abstract**

A method of improving efficiency of solar cells made of crystalline silicon, including monocrystalline silicon, multicrystalline silicon and polycrystalline silicon is provided. In the method, a negative bias pulse is applied to solar cells at a predetermined voltage, a predetermined frequency, and a predetermined pulse width while immersing the solar cells in a hydrogen plasma. Hydrogen ions are attracted and quickly implanted into the solar cells. Thus, the passivation of crystal defects in the solar cells can be realized in a short period. Meanwhile, the properties of an antireflection layer cannot be damaged as proper operating parameters are used. Consequently, the serious resistance of the solar cells can be significantly reduced and the filling factor increases as a result. Further, the short-circuit current and the open-circuit voltage can be increased. Therefore, the efficiency can be enhanced.

## Description

### BACKGROUND OF THE INVENTION

### Field of the Invention

The present invention relates to a method of hydrogenation of silicon substrates, and more particularly to a fast hydrogenation process to passivate silicon crystal defects in solar cells made of crystalline silicon (c-Si) including monocrystalline silicon (m-Si), multicrystalline silicon (mc-Si), and polycrystalline silicon (poly-Si) thin film.

### Description of Related Art

Solar cell is a very promising clean energy source which can generate electricity directly from sunlight. However, the cost of the production of solar cells needs to be significantly reduced, so as to be widely accepted as a major electricity source. It has been pointed out that the silicon wafer share is above one third of the total cost of a c-Si solar cell module. Consequently, in order to reduce the cost, making solar cells by mc-Si or poly-Si thin film has been an important development direction. However, both mc-Si and poly-Si contain defects within the crystals, including grain boundary, intragrain dislocations. Those imperfections can degrade the conversion efficiency of solar cells. Besides, the recombination of charge carriers at surfaces of the crystal lattice is detrimental to solar cells, even in the case of monocrystalline solar cells.

It has been shown that the effects of the crystal defects can be minimized by incorporating hydrogen into silicon wafers, which is called as "passivation" process. As a result, the efficiency of c-Si solar cells can be significantly improved. The general view has been that these efficiency improvements are closely related to the reduction of the charge carrier recombination losses at the crystal defects due to bonds formed by hydrogen ions on the crystal defects. Now, in techniques of manufacturing solar cells, the methods of hydrogen incorporation to alleviate the detrimental effects caused by crystal defects include:
(1) Heat treatment in hydrogen atmosphere:
   P. Sana, A. Rohatgi, J. P. Kalejs, and R. O. Bell, Appl. Phys. Lett. 64, 97 (1994), U.S. Pat. No. 5,169,791;
(2) Treatment with a hydrogen plasma:
   W. Schmidt, K.D. Rasch, and K. Roy, 16 IEEE Photovoltaic Specialist Conference, San Diego, 1982, pages 537-542,
   U. S. Pat. No. 4,835,006 and U. S. Pat. No. 4,343,830;
(3) Diffusion from hydrogen rich SiNₓ:H thin film layers deposited by plasma enchanced chemical vapor deposition (PECVD):
   R. Hezel and R. Schroner, J. Appl. Phys., 52(4), 3076 (1981);
(4) Implantation of ionized hydrogen atoms:
   U. S. Pat. No. 5,304, 509,
   J. E. Johnson, J. I. Hano Ka, and J. A. Gregory, 18 IEEE Photovoltaic Specialists Conference, Las Vegas 1985, pages 1112-1115.

For the process of hydrogen passivation, sufficient hydrogen atoms are required to form bonds on a plurality of crystal defects. However, because of the limited diffusion of hydrogen atoms through the surface of the wafer, the process time in methods from (1) to (3) is in the order of hours. Meanwhile, the process time can be significantly reduced in method (4), where the hydrogen ions are implanted into a wafer by a conventional Kaufman broad beam ion source. But in practical industrial applications, a plurality set of ion beams of large area is required to meet the mass production of solar cells, and an ion beam source equipment of such specification then becomes an expensive and complicated system. In addition, acceleration electrodes in Kaufman ion beam source are bombarded by ions during the process. The sputtered metal particles may become the source of contamination, which can degrade the performance of solar cellars.

Hydrogenated amorphous silicon nitride a-SiNₓ:H film has become an important application in solar cells, which is deposited on the silicon wafer by PECVD. The first purpose of the application of a-SiNₓ:H film is to function as an antireflection coating. Secondly, it can provide a surface passivation effect, to reduce the recombination of charge carriers at the surface of silicon wafer in solar cells. Additionally, the hydrogen atoms in a-SiNₓ:H film can diffuse into silicon bulk and passivate the defects of the crystal lattice. For this purpose, thermal process is required to raise the temperatures of the solar cells for increasing the diffusion of hydrogen atoms to achieve optimum passivation. The operating temperature is around 350 °C and the passivation process usually takes 1 to 2 hours.

In the production of some solar cells, the electrodes are fabricated after completing the antireflection coating. As the fabrication of electrode always needs to perform a step of high-temperature heating and baking, and the bond of hydrogen and silicon will be discomposed above 400°C, and hydrogen atoms will leave the wafer, the effects of hydrogen passivation will be damaged.

In view of above, there is a need for a fast hydrogen passivation which can significantly reducing the process time in the production of c-Si solar cells. Especially, such process can be performed after the fabrication of c-Si solar cells. In other words, it is a fast hydrogen passivation process that still can be performed after the deposition of the antireflection coating and the fabrication of the electrodes. Furthermore, the implement of this method must be simpler and more adaptable to the mass production process for solar cells, compared with the conventional ion implantation by Kaufman broad beam ion source.

### SUMMARY OF THE INVENTION

Accordingly, the present invention is directed to provide a method of hydrogen passivation to c-Si solar cells, so as to improve the performance of c-Si solar cells. The method can be used to realize a fast hydrogen passivation to alleviate the detrimental effects caused by the defects in silicon crystals. Furthermore, this method must not cause damage to the antireflection coating such as a-SiNₓ:H films. In addition, the method of hydrogen passivation of c-Si solar cells can improve the performance of the solar cells which have been completely fabricated.

The present invention provides a method of hydrogen passivation to c-Si solar cells, which includes the following steps.

(a) Place a c-Si solar cell into a vacuum chamber, in which electrodes and an antireflection coating are disposed on the surface of the c-Si solar cell.

(b) Supply hydrogen gas into the vacuum chamber to a predetermined pressure.

(c) Transmit a radio frequency (RF) or microwave power into the vacuum chamber to produce a hydrogen plasma.

(d) Provide a negative pulse bias to the c-Si solar cell wafer by a pulse generator at a predetermined voltage, a predetermined frequency, and a predetermined time width, and implant sufficient hydrogen ions into the c-Si solar cell wafer in a predetermined time period, in which the negative pulse voltage is controlled in a set range to avoid damaging the antireflection coating.

The method of hydrogen passivation to c-Si solar cells provided by the present invention includes the following steps. First, a c-Si solar cell wafer is placed in a vacuum chamber, and the solar cell has had an antireflection coating and electrodes. Next, a hydrogen gas is supplied into the vacuum chamber to a predetermined pressure. And then, a RF or microwave power source is transmitted into the vacuum chamber to produce a hydrogen plasma. Afterwards, a negative bias pulse is provided to the solar cell wafer, so as to attract and implant the hydrogen ions therein.

In this method, high-density plasma can provide a high dose rate of hydrogen ions. Compared with the existing techniques, the process time can be significantly reduced. On the other hand, compared with conventional ion beam process, the implements of this method are much simpler and more economical in a mass production process. Meanwhile, the accumulation of implanted charges can be neutralized by electrons from the plasma between negative bias pulses. So, the problem of damages by charging accumulation can be obviated by controlling the pulse width. Meanwhile, the possible deterioration of the antireflection coating by the bombardment of ions can be averted by choosing a proper pulse voltage.

In order to make the aforementioned and other objects, features and advantages of the present invention comprehensible, preferred embodiments accompanied with figures are described in detail below.

It is to be understood that both the foregoing general description and the following detailed description are exemplary, and are intended to provide further explanation of the invention as claimed.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIG. 1 is a cross-sectional front view of a typical solar cell.

FIG. 2 is a schematic view showing the hydrogen possivation to c-Si solar cells of the present invention.

FIG. 3 is a plot of the electrical characteristics (I-V) of a solar cell made of a multicrystalline silicon illustrated in FIG. 1 before and after hydrogen passivation, under simulated AM1.5 illumination.

FIG. 4 is a plot of the electrical characteristics (I-V) of a solar cell made of monocrystalline silicon as illustrated in FIG. 1 before and after hydrogen passivation, under simulated AM1.5 illumination.

### DESCRIPTION OF EMBODIMENTS

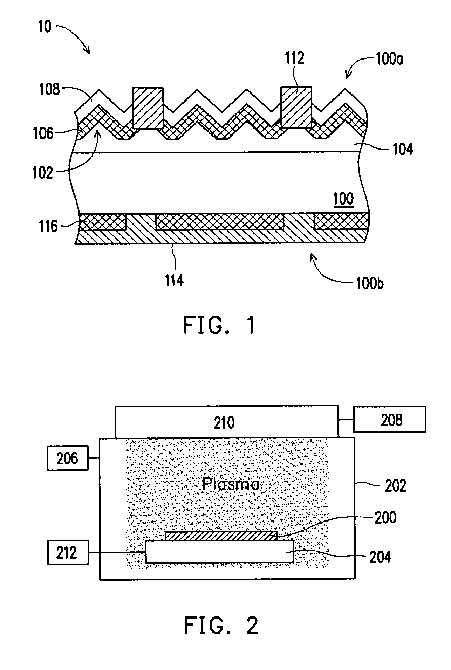

FIG. 1 is a typical solar cell 10, which includes a c-Si wafer 100 having a pn junction 104 formed thereon. The surface of the wafer has random pyramid textures 13. A thin layer of SiO₂ 14 grown by thermal process is used to serve as a surface passivation layer 106. And then, an antireflection coating 108 of an a-SiNₓ: H film is deposited by means of PECVD. Electrodes 112 and 114 are fabricated respectively on a front surface 100a and a rear surface 110b of the c-Si wafer 100. Additionally, the electrode 114 is generally formed in a dielectric layer 116 deposited on the rear surface 100b of the c-Si wafer 100.

FIG. 2 is a schematic view showing the hydrogen possivation to a c-Si solar cell wafer 200. First, the c-Si solar cell wafer 200 is placed on a wafer holder 204 in a vacuum chamber 202, and the pressure in the vacuum chamber 202 is reduced to approximately 10⁻⁶ Torr. Next, a gas supply equipment 206 supplies hydrogen gas into the vacuum chamber 202 to predetermined pressure, approximately 1-10 mTorr. And then, a microwave or RF power is transmitted into the vacuum chamber 202 by a microwave or RF power generator 208, so as to produce a hydrogen plasma. Generally, the plasma density should be higher than 10⁻¹⁰ cm⁻³ to achieve an effective process.

After the plasma is excited, a negative pulse voltage is provided to the wafer holder 204 by a pulse generator 212 at predetermined voltage, predetermined pulse frequency, and predetermined pulse time width, so as to apply a bias on the c-Si solar cell wafer 200. The pulse frequency of the negative pulse voltage is from 100 Hz to 20 kHz. The voltage range is from -500 V to -5 kV, so as to ensure the antireflection layer (such as 108 in FIG. 1) in the c-Si solar cell wafer 200 will not be damaged during hydrogen passivation. And the pulse duration of the negative pulse voltage is from I µsec to 20 µsec. Then, hydrogen ions from a plasma source 210 are accelerated by the negative voltage and implanted into c-Si solar cell wafer 200. The period of the process is between 1 to 10 min. Additionally, during implanting the hydrogen ions, the temperature of the c-Si solar cell wafer 200 is maintained at approximately 300 to 350°C by an external heating power source.

The following examples will illustrate the effects of hydrogen passivation of the present invention.

Example 1

In this example, the base pressure of the vacuum chamber is 10⁻⁶ Torr, and then hydrogen gas is intruded into the vacuum chamber as a working gas and the pressure is raised to 2 mTorr. The plasma is excited by a RF power (13.56 MHz) through an inductive coupling antenna with a power of 200 W. The plasma density is approximately 10¹¹ cm⁻³. Furthermore, a bias is applied to the solar cell by a pulse voltage of -4 kV. The pulse width is 10 µsec and the pulse frequency is 200 Hz. In this experiment, no power supply is provided to heat the solar cell, but the temperatures of the samples are approximately 100°C resulting from the plasma ions implantation. The total process time is 10 min.

Solar cells are fabricated by mc-Si wafers that are p-type, boron doped to 1 x 10²⁰ cm⁻³. Their mean grain size is approximately 5 mm. Random pyramid textures have been made on the front surface of the wafer. N⁺P junctions are fabricated by diffusion of POCL₃ at 850°C for 20 min. Next, a SiO₂ layer of 20 nm is formed by an oxidized thermal process. Afterwards, an a-SiNₓ:H film of approximately 90 nm is deposited for antireflection by a capacitively coupled RF plasma reactor at temperature of 350°C, with SiH₄ and NH₃ as precursors. Metallic contacts are made by metal printing and firing at 750°C.

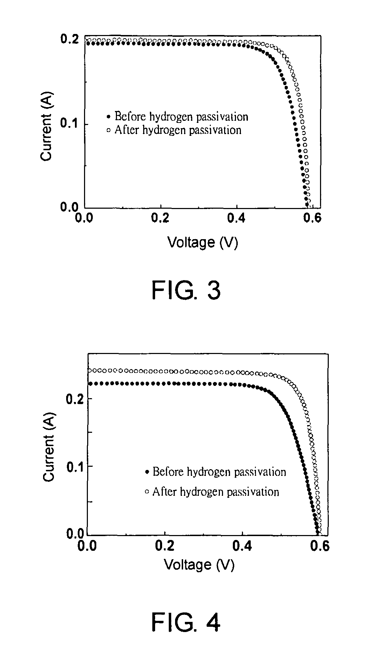

FIG. 3 is the comparison of current-voltage characteristics the solar cell before and after hydrogen passivation. It is shown by the results that the serious resistance is significantly reduced and the filling factor increases from 76.99% to 81.25%, and the short-circuit current is increased. These improvements lead to an increase of the conversion efficiency from 12.33% to 13.39 %.

Example 2

In this example, a solar cell made of a monocrystalline silicon wafer is fabricated. The structure and the process of the fabrication are as same as in example 1. In addition, the plasma condition and treatment conditions are also the same. FIG. 4 is the comparison of current-voltage characteristics the solar cell before and after hydrogen passivation. It is shown by the results that the filling factor increases from 75% to 80.77 % as a result. Meanwhile, the short-circuit current increases from 0.23 A to 0.25 A and the open voltage increase from 0.59 V to 0.6 V as well. These improvements lead to an increase of the conversion efficiency from 14.25 % to 17.06 %.

In view of above, compared with the existing techniques, the present invention can significantly reduce the time and the cost of hydrogen passivation, and effectively improve the efficiency of c-Si solar cells. Furthermore, the implements of this method are simpler and more economical in a mass production process. The present invention can be applied to various types of c-Si solar cells. Especially, the present invention can perform hydrogen passivation to the solar cells which fails to meet the requirements for efficiency in the production, so as to improve the efficiency and increase the production yield. In addition, the present invention is not required to change the existing production methods of solar cells, so it is independent process and has high conformability.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A method of hydrogen passivation to c-Si solar cells, comprising:
(a) placing a c-Si solar cell wafer into a vacuum chamber, wherein electrodes and an antireflection coating are disposed on a surface of the c-Si solar cell wafer;
(b) supplying a hydrogen gas into the vacuum chamber to a predetermined pressure;
(c) transmitting a radio frequency (RF) or a microwave power into the vacuum chamber to produce a hydrogen plasma; and
(d) providing a negative pulse voltage to the c-Si solar cell wafer by a pulse generator at a predetermined voltage, a predetermined frequency, and a predetermined time width, and implanting sufficient hydrogen ions into the c-Si solar cell wafer in a period of the process, wherein the negative pulse voltage is controlled in a set range to avoid damaging the antireflection coating.

2. The method of hydrogen passivation to c-Si solar cells as claimed in claim 1, wherein the negative pulse voltage is between -500 V and -10 kV.

3. The method of hydrogen passivation to c-Si solar cells as claimed in claim 1, wherein the time for supplying the negative pulse voltage is between 1 µsec and 20 µsec.

4. The method of hydrogen passivation to c-Si solar cells as claimed in claim 1, wherein the pulse frequency is between 100 Hz and 20 kHz.

5. The method of hydrogen passivation to c-Si solar cells as claimed in claim 1, wherein the period of the process is between 1 min and 10 min.

6. The method of hydrogen passivation to c-Si solar cells as claimed in claim 1, wherein in step d, the method further comprises heating the c-Si solar cell wafer to a temperature of 300 to 350 °C.
